# EUROPÄISCHE PATENTANMELDUNG

(11) **EP 2 058 869 A1**
(43) Veröffentlichungstag der Anmeldung: **13.05.2009**
(21) Anmeldenummer: 07021561.1
(22) Anmeldetag: 06.11.2007
(51) Int. Cl.: H01L 31/052, H01L 27/142, H01L 31/0224

(54) **Solarzellenmodul mit angepasster Solarzellenbreite**

(71) Anmelder: Fraunhofer-Gesellschaft zur Förderung der angewandten Forschung e.V., 80686 München (DE)
(72) Erfinder: Löckenhoff, Rüdiger, 79110 Freiburg (DE)
(74) Vertreter: Pfenning, Meinig & Partner GbR

(57) **Zusammenfassung**

Die vorliegende Erfindung bezieht sich auf ein Solarzellenmodul umfassend mindestens drei im Wesentlichen in einer Reihe angeordnete, elektrisch in Serie geschaltete Solarzellen (Reihenanordnung von Solarzellen 1a, 1i), wobei mindestens eine Solarzelle (innen liegende Solarzelle 1i) der Reihenanordnung von Solarzellen eine geringere solarstrahlungssensitive Fläche aufweist als zwei in Reihenrichtung R gesehen beidseits dieser innen liegenden Solarzelle angeordneten Solarzellen (außen liegende Solarzellen 1a) der Reihenanordnung.

## Beschreibung

Die vorliegende Erfindung bezieht sich auf Photovoltaikmodule (nachfolgend auch alternativ als Solarzellenmodule bezeichnet), welche in optischen Konzentratorsystemen für Solarstrahlung eingesetzt werden können. Die einzelnen Solarzellenmodule bzw. Solarmodule umfassen hierbei mehrere miteinander elektrisch verschaltete Solarzellen. Die vorliegende Erfindung bezieht sich darüber hinaus ebenso auf ein Konzentratorsystem für Solarstrahlung, welches ein entsprechendes Solarzellenmodul verwendet, sowie auf Verfahren zur Energieerzeugung aus Solarstrahlung und Verfahren zur Korrektur der Sonnenlichteinfallposition auf einem Solarzellenmodul eines Konzentratorsystems.

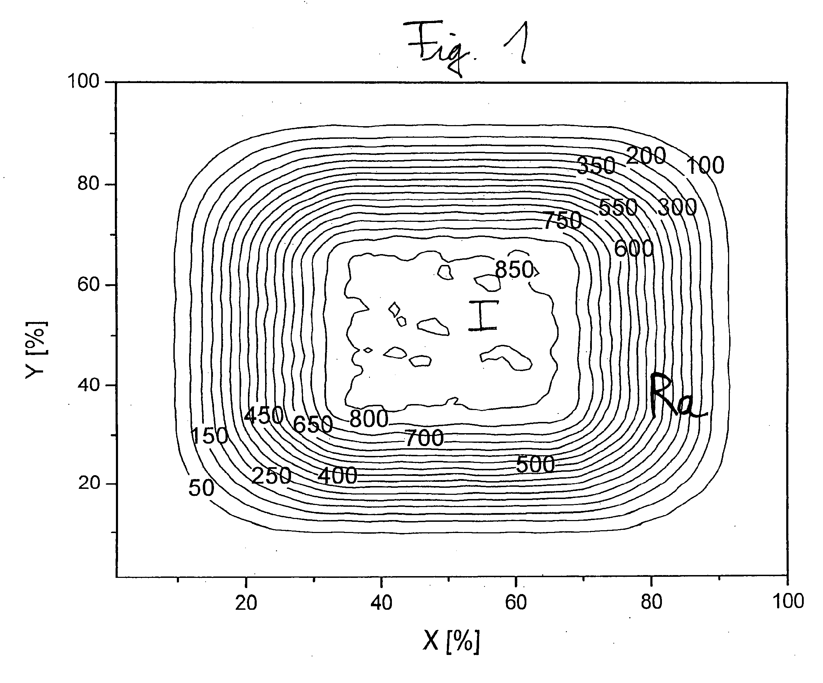

Solarzellenmodule werden in optischen Konzentratorsystemen, welche beispielsweise als Fokussieroptik konzentrierende Hohlspiegel umfassen, eingesetzt. Die Solarmodule sind nach dem Stand der Technik dabei in der Regel rechteckförmig und erfordern eine homogene Beleuchtung. Da die Sonne keine Punktlichtquelle ist, ist es nicht möglich, einen derartigen rechteckigen Lichtfleck mit einer einstufigen Optik zu erreichen. In der Regel ist die Lichtverteilung rotationssymmetrisch oder zumindest gegenüber der Rechteckform abgerundet. Die Lichtintensität ist im Lichtfleck an der Position des Solarzellenmoduls daher nicht konstant, sondern fällt an den Rändern langsam ab (siehe hierzu Fig. 1).

In zweistufigen Konzentratoroptiken nach dem Stand der Technik werden homogenisierende Elemente wie beispielsweise ein aus mehreren Spiegeln gebildetes Rohr verwendet. Auf die Öffnung dieses Rohres wird das Licht fokussiert. Durch die Mehrfachreflexion des Lichts im Rohr entsteht eine homogenere Lichtverteilung. Am Austritt des Rohres fällt die Lichtintensität am Rand des Spiegels abrupt auf null ab. Derartige Sekundäroptiken werden als Homogenisierer oder auch als Kaleidoskope bezeichnet. Sie können neben der Homogenisierung auch noch eine weitere optische Konzentration des Lichts bewirken. Ein Beispiel sind sogenannte "Compound Parabolic Concentrators" CPC.

Derartige Sekundäroptiken nach dem Stand der Technik haben jedoch den Nachteil, dass durch sie zusätzliche optische Verluste, welche in der Regel mehr als 3 % bei jeder Reflexion des Lichts betragen, generiert werden. Darüber hinaus verursachen die Sekundäroptiken zusätzliche Kosten und verkomplizieren den Aufbau. Zudem müssen solche Sekundäroptiken sauber gehalten werden, was zusätzlichen Wartungsaufwand bedingt. Darüber hinaus ist ggf. eine aktive Kühlung erforderlich, um die Abwärme aus den Sekundäroptiken abzuführen.

Aufgabe der vorliegenden Erfindung ist es daher, ein Solarzellenmodul und ein ein solches Solarzellenmodul verwendendes Konzentratorsystem für Solarstrahlung zur Verfügung zu stellen, welche es erlauben, auch unter inhomogener Lichteinstrahlung auf einfache Art und Weise sowie möglichst effizient zu arbeiten. Aufgabe ist es darüber hinaus, entsprechende Verfahren zum Betrieb von Konzentratorsystemen bzw. Solarzellenmodulen, also zur Energieerzeugung aus Solarstrahlung, zur Verfügung zu stellen. Aufgabe ist es darüber hinaus, ein Verfahren zur Korrektur der Sonnenlichteinfallposition auf einem Solarzellenmodul eines Konzentratorsystems für Solarstrahlung zur Verfügung zu stellen.

Die erfindungsgemäße Aufgabe wird durch das Solarzellenmodul gemäß Anspruch 1, das Konzentratorsystem gemäß Anspruch 9 sowie die Verfahren gemäß Anspruch 16 und Anspruch 18 gelöst. Vorteilhafte Ausgestaltungsformen der erfindungsgemäßen Vorrichtungen sowie der erfindungsgemäßen Verfahren ergeben sich aus den jeweiligen abhängigen Ansprüchen. Erfindungsgemäße Verwendungen werden in dem Anspruch 19 beschrieben.

Die einzelnen Merkmale, wie sie in den nachfolgend beschriebenen vorteilhaften Ausführungsbeispielen der vorliegenden Erfindung beschrieben sind, können im Rahmen der Erfindung nicht nur in den in den Ausführungsbeispielen gezeigten Kombinationen auftreten bzw. verwendet werden, sondern können entsprechend des Fachwissens des Fachmannes auch in anderen Kombinationen eingesetzt bzw. verwendet werden.

Erfindungsgemäß erfasst ein Solarzellenmodul mehrere (mindestens drei) im Wesentlichen in einer Reihe angeordnete einzelne Solarzellen, welche elektrisch in Serie geschaltet sind. Eine solche Menge von in Reihe angeordneten Solarzellen wird nachfolgend auch als Reihenanordnung von Solarzellen, welche, wie nachfolgend noch näher beschrieben, innere Solarzellen (im Bereich des Zentrums der Reihenanordnung angeordnete Solarzellen) sowie äußere Solarzellen (zum Rand hin angeordnete Solarzellen) aufweist, bezeichnet. Erfindungsgemäß weist mindestens eine der innen liegenden Solarzellen der Reihenanordnung eine geringere solarstrahlungssensitive Fläche bzw. Oberfläche auf als zwei in Reihenrichtung gesehen beidseits dieser innen liegenden Solarzellen angeordnete äußere bzw. außen liegende Solarzellen. Der Begriff der "äußeren" Solarzelle bedeutet somit nicht, dass es sich lediglich um diejenigen beiden am weitesten vom Zentrum entfernt (bzw. an den Enden der Reihe) liegenden Solarzellen handelt, sondern es kann sich bei "äußeren Solarzellen" beidseits um mehrere Solarzellen handeln: lediglich das Verhältnis der solarstrahlungssensitiven Flächen der Solarzellen ist für ihre Definition als "innere" oder "äußere" Solarzellen relevant; bei mehr als zwei verschiedenen solarstrahlungssensitiven Solarzellenflächen kann die Grenze zwischen inneren und äußeren Solarzellen auf unterschiedliche Art gezogen werden, z.B. anhand eines arithmetischen Mittelwerts der verschiedenen auftretenden Flächengrößen.

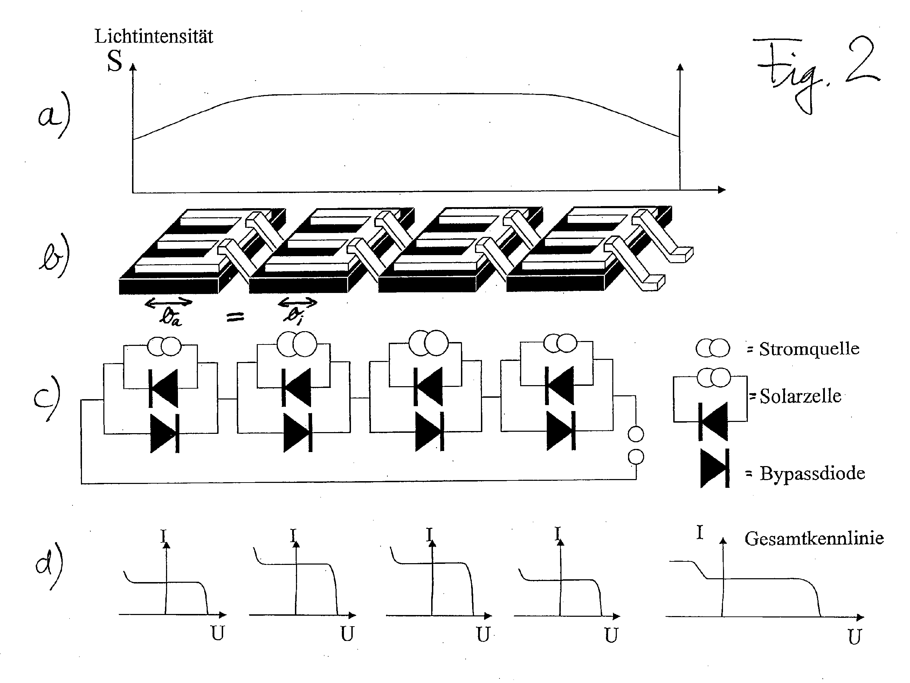

Im einfachsten Fall besteht somit das erfindungsgemäße Solarmodul aus einer einzelnen Reihenschaltung von einzelnen Solarzellen. Die äußeren Solarzellen werden auf der abfallenden Flanke der Lichtverteilung betrieben. Hätten nun alle Solarzellen dieselbe Fläche, so würden die äußeren Solarzellen einen geringeren Strom generieren. In Solarzellen kann jedoch in Betriebsrichtung maximal der Kurzschlussstrom fließen, gegenüber höheren Strömen sperren sie. Dementsprechend begrenzen die äußeren Solarzellen den Strom der gesamten Serienschaltung bzw. Reihenanordnung (siehe dazu auch das Ersatzschaltbild in Fig. 2). Die Strombegrenzung könnte nun durch Verwendung von Bypassdioden abgemildert werden, welche den Strom an den begrenzenden Solarzellen vorbeileiten. Es ginge jedoch in diesem Fall auch an den Bypassdioden Spannung verloren, anstatt dass die entsprechenden Solarzellen Spannung generieren. Eine Strombegrenzung einzelner Solarzellen in einer Serienverschaltung ist daher zu vermeiden.

Aus diesem Grund wird erfindungsgemäß die strombegrenzende Wirkung der außen liegenden Solarzellen der Reihenanordnung von Solarzellen dadurch vermieden, dass die Fläche der äußeren Solarzellen, insbesondere vorteilhafterweise ihre Breite in Reihenanordnungsrichtung bzw. Verschaltungsrichtung der Serienschaltung, erhöht wird. So kann beispielsweise eine auf 2/3 reduzierte Lichtintensität am Rande der auf die Solarzellenanordnung eingestrahlten Lichtverteilung durch eine auf 3/2, also um 50 %, erhöhte Solarzellenbreite kompensiert werden.

Lichtkonzentrierende Fokussieroptiken von Konzentratorsystemen (dabei kann es sich beispielsweise um Parabol- bzw. Hohlspiegel handeln) müssen der Sonne nachgeführt werden, um zu verschiedenen Tageszeiten die Solarzellenanordnung optimal auszuleuchten. Dabei verursacht die Winkelabweichung der Nachführung eine Verschiebung des Lichtflecks, welcher auf das Solarzellenmodul bzw. die Solarzellen eingestrahlt wird. Die Kompensation der zum Rande hin abfallenden Lichtintensität durch die in diese Richtung zunehmende Solarzellenbreite bezieht sich erfindungsgemäß deshalb jeweils auf den ungünstigsten Fall. Diese Verschiebung des Lichtflecks führt an einer Seite bzw. Außenseite der Reihenanordnung zu einer weiteren Verringerung der Lichtintensität, die wiederum durch eine weitere Erhöhung der solarstrahlensensitiven Solarzellenfläche (insbesondere Solarzellenbreite) ausgeglichen werden kann. Hierbei muss die Kompensation auf beiden Seiten (bzw. Außenseiten der Reihenanordnung) der Serienverschaltung erfolgen. Im Betrieb ohne Winkelabweichung fällt damit auf die solarstrahlungssensitive Fläche der äußeren Solarzellen etwas mehr Licht, als auf die Fläche der inneren Solarzellen. Die inneren Solarzellen sind dann strombegrenzend. Da die inneren Solarzellen in der Regel die Mehrzahl der Solarzellen bilden, ist dies akzeptabel. Im Einzelfall ist bei bekannter Lichtverteilung und bekannter typischer Winkelabweichung der Nachführung die Solarzellenfläche bzw. -breite vorteilhafterweise derart abzustimmen, dass im Zeitmittel eine möglichst hohe Leistung des Solarzellenmoduls erreicht wird.

Die nachfolgend noch anhand von Ausführungsbeispielen näher beschriebenen erfindungsgemäßen Solarzellenmodule können bei Lichtintensitäten eingesetzt werden, welche um einen Faktor 20 bis 2000 höher sind als die Lichtintensität des Sonnenlichtes (d. h. 20 bis 2000 kW/m²). Bei derartig hohen Lichtintensitäten ist in der Regel eine aktive Wasserkühlung des Solarzellenmoduls notwendig. Solche Wasserkühlungen sind dem Fachmann jedoch bekannt, so dass sie nachfolgend nicht näher beschrieben werden.

### Es zeigen:

- Fig. 1: eine inhomogene Intensitätsverteilung bei Einstrahlung von Solarstrahlung mittels der Fokussieroptik eines Konzentratorsystems auf die Solarzellenanordnung bzw. das Solarzellenmodul des Konzentratorsystems.
- Fig. 2: eine serienverschaltete Solarzellenanordnung eines Solarzellenmoduls nach dem Stand der Technik.
- Fig. 3: ein erfindungsgemäßes Solarzellenmodul in Reihenschaltung.
- Fig. 4: ein als monolithisch integriert serienverschaltetes, auf einem einzigen Wafer ausgebildetes erfindungsgemäßes Solarzellenmodul.
- Fig. 5a: die Skizze eine monolithisch integriertserienverschalteten Solarzellenmoduls (nachfolgend auch: MIMs), dessen Rückseitenkontakt auf der Querleitschicht von einem einzelnen, schmalen Kontaktstreifen gebildet wird.
- Fig. 5b: die Skizze eines MIMs, bei dem der Rückseitenkontakt durch Kontaktfinger ergänzt wird, welche innerhalb von geätzten Gräben auf der Querleitschicht verlaufen (der Rückkontakt ist nunmehr kammförmig).
- Fig. 6: die wesentlichen Komponenten eines erfindungsgemäßen Konzentratorsystems.
- Fig. 7: die wesentlichen Komponenten eines erfindungsgemäßen Konzentratorsystems zur Kor-
rektur der Sonnennachführung.

Fig. 1 zeigt die Intensitätsverteilung, welche durch eine Fokussieroptik 4 eines Konzentratorsystems auf einem Solarzellenmodul 1 erzeugt wird. Wie die Figur deutlich zeigt, fällt die lediglich im Innenbereich I nahezu homogene Intensitätsverteilung am Rand Ra des Innenbereiches I stark ab (Inhomogenität der Intensitätsverteilung in den Randbereichen).

Fig. 2 zeigt ein Solarzellenmodul nach dem Stand der Technik. Dieses besteht hier aus lediglich vier in einer Reihe angeordneten, einzelnen Solarzellen (Fig. 2b), welche in Reihenrichtung elektrisch in Serie miteinander verschaltet sind. Alle einzelnen Solarzellen weisen in Verschaltungsrichtung dieselbe Breite b auf, d. h. die äußeren Solarzellen weisen die Breite bₐ auf, welche der Breite bᵢ der inneren Solarzellen entspricht. Aufgrund der zum Rand hin abfallenden Intensitätsverteilung (Fig. 2a) erzeugen die randseitig angeordneten Solarzellen eine geringere Strommenge. Fig. 2c zeigt hierbei ein Ersatzschaltbild des gezeigten beispielhaften Solarzellenmoduls nach dem Stand der Technik (zu jeder Solarzelle ist hier jeweils eine Bypassdiode parallel geschaltet). Fig. 2d zeigt im linken Bereich (vier einzelne Schaubilder) jeweils die einzelnen von den Solarzellen erzeugten Strommengen (die rechte Kennlinie zeigt die Gesamtkennlinie der Solarzellenanordnung von Fig. 2b und 2c). Wie Fig. 2d links zu entnehmen ist, erzeugen die randliegenden Solarzellen aufgrund des in Fig. 2a gezeigten Intensitätsabfalls des eingestrahlten Lichts zum Rand hin lediglich geringere Ströme I.

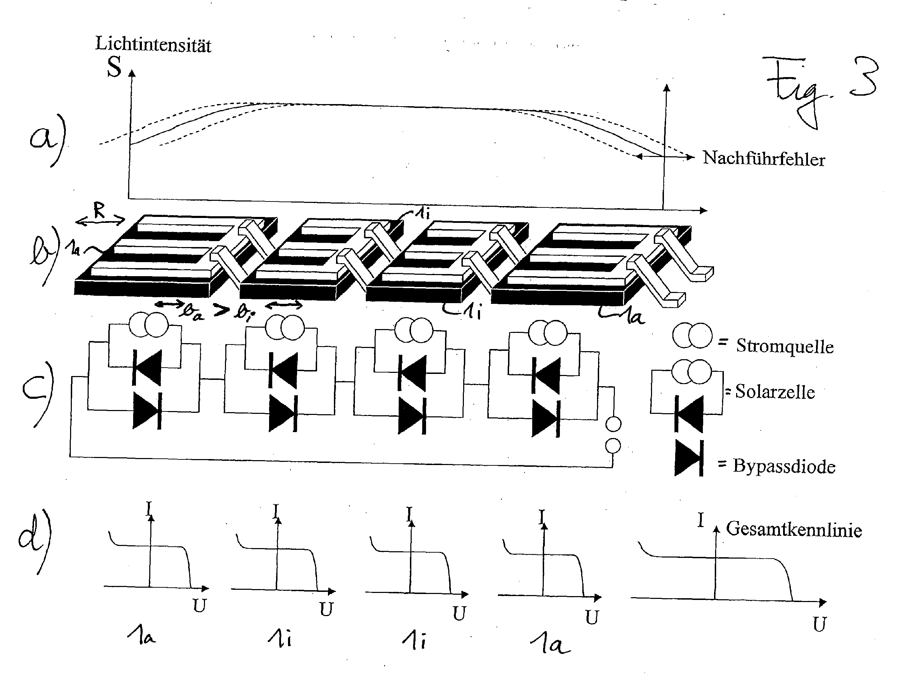

Fig. 3 zeigt nun ein einfaches Beispiel für eine erfindungsgemäße Anordnung von Solarzellen in einem Solarzellenmodul. In diesem Beispiel sind vier einzelne Solarzellen 1a, 1i nebeneinander auf einem Substrat (nicht gezeigt) und in einer Reihe (Reihenrichtung: R) angeordnet. Die einzelnen Solarzellen bzw. ihre strahlungssensitiven Flächen sind hierbei in einer Ebene nebeneinander und beabstandet voneinander in der Reihe R angeordnet. Die in Reihenrichtung R innen liegenden, im Zentrum der Reihe angeordneten Solarzellen sind mit den Bezugszeichen 1i (innen liegende Solarzellen) bezeichnet. Die beidseits außerhalb dieser beiden innen liegenden Solarzellen 1i angeordneten beiden außen liegenden Solarzellen, welche den Rand der Solarzellenanordnung bilden, sind mit dem Bezugszeichen 1a versehen.

Erfindungsgemäß wird nun die in Fig. 3a gezeigte, zum Rand hin abfallende Lichtintensität (siehe Beschreibung zu Fig. 2) dadurch ausgeglichen, dass die solarstrahlungssensitive Fläche der außen liegenden Solarzellen 1a gegenüber der solarstrahlungssensitiven Fläche der innen liegenden Solarzellen 1i erhöht bzw. vergrößert wird. Dies ist im Beispiel dadurch realisiert, dass die Breite bₐ der außen liegenden Solarzellen 1a gegenüber der Breite bᵢ der innen liegenden Solarzellen 1i erhöht ist (es gilt somit bₐ > bᵢ, wobei die Breite jeweils in Reihenanordnungsrichtung R bzw. in Richtung der seriellen elektrischen Verschaltung der einzelnen Solarzellen miteinander gemessen wird). Vorteilhafterweise beträgt hierbei das Verhältnis der solarstrahlungssensitiven Fläche mindestens einer der außenliegenden Solarzellen 1a der Reihenanordnung von Solarzellen und der solarstrahlungssensitiven Fläche mindestens einer der innenliegenden Solarzellen 1i der Reihenanordnung von Solarzellen über 1,1, bevorzugt über 1,25, bevorzugt über 1,5, bevorzugt über 1,75 oder bevorzugt über 2,0.

Vorzugsweise erfolgt die Vergrößerung der Fläche bzw. der Breite der Solarzellen nach außen zum Rand hin dabei entsprechend dem konkreten Lichtintensitätsabfall, welcher durch die Ausgestaltung des Konzentratorsystems, in dem das gezeigte Solarzellenmodul eingesetzt wird, verursacht wird. Der Abfall ist hierbei durch die Anordnung der einzelnen Elemente des Konzentratorsystems sowie durch ihre Ausgestaltung vorgegeben: Entscheidend hierbei ist vor allen Dingen die Anordnung des Solarzellenmoduls relativ zur Fokussieroptik 4 des Konzentratorsystems sowie die konkrete Ausgestaltung der Fokussieroptik 4. Idealerweise wird somit der Abfall der Lichtintensität zum Rand hin durch eine entsprechende Vergrößerung der Fläche bzw. der Breite b zum Rand hin genau ausgeglichen.

Fig. 3c zeigt wieder das entsprechende Ersatzschaltbild der in Fig. 3b gezeigten Solarzellenanordnung mit einer parallel geschalteten Bypassdiode je Solarzelle. Fig. 3d zeigt die in den einzelnen Solarzellen 1a und 1i beim Betrieb jeweils generierten Stromstärken (Strom-Spannungs-Kennlinie). Wie den vier einzelnen Schaubildern in Fig. 3d links klar zu entnehmen ist, erzeugen nunmehr aufgrund der vorbeschriebenen Ausgestaltung alle vier einzelnen Solarzellen denselben Strom (Fig. 3d ganz rechts zeigt die resultierende Gesamtstromkennlinie).

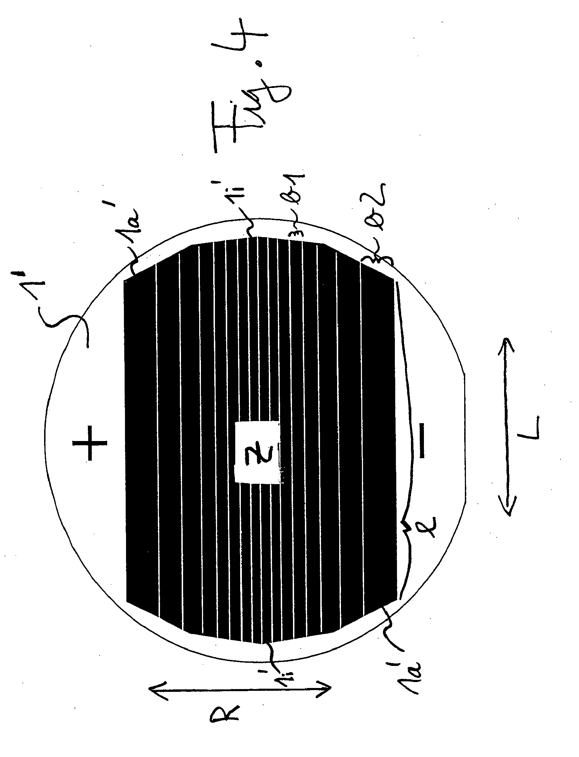

Fig. 4 zeigt einen konkreten Anwendungsfall eines erfindungsgemäßen Solarzellenmoduls: Das Solarzellenmodul ist hierbei als monolithisch integriert serienverschaltetes Solarzellenmodul 1' ausgebildet, welches auf einem einzigen Wafer integriert ist. Die konkrete Ausbildung eines solchen Moduls ist, bis auf die erfindungsgemäße Ausgestaltung der solarstrahlungssensitiven Flächen der einzelnen Solarzellen, dem Fachmann bekannt aus "1000 Sun, Compact Receiver Based on Monolithic Interconnected Modules (MIMS)", von R. Löckenhoff et al., präsentiert auf der 2006 IEEE 4th World Conference on Photovoltaic Energy Conversion, May 7-12, 2006, Hawaii; diese Veröffentlichung wird hiermit hinsichtlich der konkreten Schichtenfolge und Materialwahl der Solarzellen des in Fig. 4 gezeigten Beispiels in ihrem vollen Umfang in die vorliegende Patentanmeldung integriert.

Wie Fig. 4 skizziert, nimmt in Reihenanordnungsrichtung R der einzelnen Solarzellen 1a', 1i' und vom Zentrum Z zum Rand hin gesehen (die Ränder sind hier mit + und - gekennzeichnet) die Breite b der einzelnen Solarzellen, welche hier als Solarzellensegmente ausgebildet sind, zu. Die am weitesten außen liegenden Solarzellen 1a' weisen die höchste Breite b2 auf. Weiter innen liegende Solarzellen weisen eine geringere Breite b1 auf, während die im Zentrum angeordneten Solarzellen (hier mit 1i' gekennzeichnet) die geringste Breite b aufweisen.

Das gezeigte monolithisch integriert serienverschaltete Solarzellenmodul 1', welches nachfolgend als MIM (von englisch monolithic interconnected module) bezeichnet wird, weist somit mehrere Solarzellensegmente 1a', 1i' auf, welche in einer Reihe R und nebeneinander auf einem gemeinsamen Chip bzw. Wafer integriert und in Serie verschaltet sind. Die an den Rändern angeordneten Solarzellensegmente des MIMs (wo die Lichtintensität niedriger ist) weisen eine höhere Segmentbreite b auf als die Solarzellensegmente in jenem Bereich, welcher der Modulmitte zugewandt ist bzw. dieser entspricht (Zentrum Z). Durch die monolithische Serienverschaltung können MIMs bei gleicher Effizienz beliebig groß ausgelegt werden. Eine praktische Obergrenze stellt allerdings die Waferfläche dar, im gezeigten Fall ein Wafer mit 4 Zoll Durchmesser.

Erfindungsgemäß ist hierbei vorteilhafterweise ein einziges MIM auf dem gezeigten Wafer integriert, wobei die Gesamtfläche des MIMs (dies ist die Summe der strahlungssensitiven Flächen der einzelnen Solarzellensegmente des Solarzellenmoduls) mehr als die halbe Fläche des Wafers, aus dem es hergestellt wurde, aufweist. Eine solche Anordnung hat den Vorteil, dass, da die Wafer nach ihrer Herstellung nahezu kreisscheibenförmig sind, das MIM nicht auf ein rechteckiges Modul beschränkt ist. Letzteres hätte hohe Flächenverluste zur Folge. Die Verwendung eines kreisscheibenförmigen Wafers und eines näherungsweise an diese Form angepassten MIMs hat zudem den Vorteil, dass das Konzentrationssystem nahezu rotationssymmetrische Lichtflecke erzeugt: Demgemäß ist ein runder Wafer bzw. ein nahezu rundes MIM sehr gut als Empfänger an ein solches konzentrierendes System angepasst.

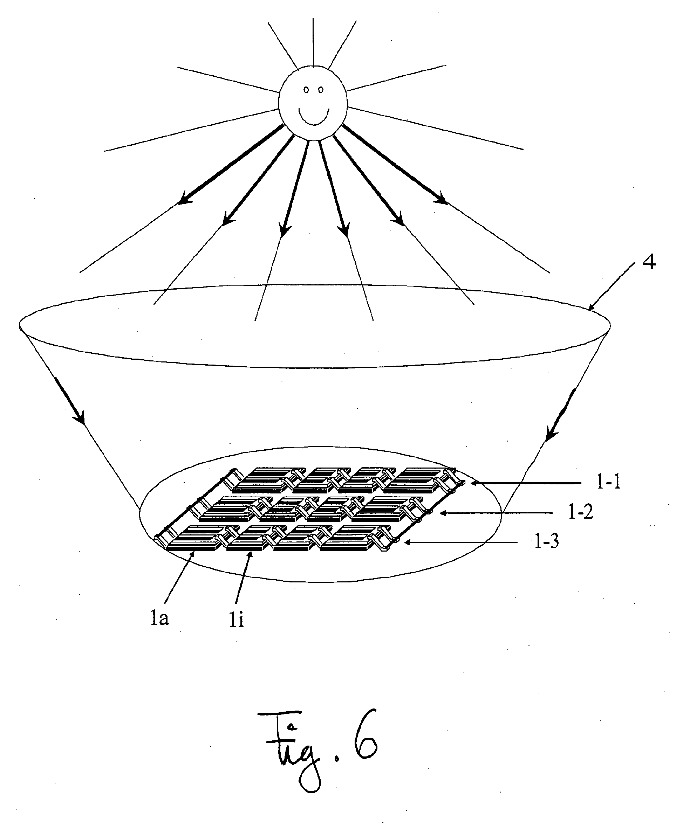

Besonders vorteilhaft besteht somit das Solarzellenmodul aus einem einzigen MIM, wobei dieses MIM als einziges MIM auf einem Standardwafer hergestellt ist. Unter einem Standardwafer wird hier ein Wafer, wie er kommerziell für die Chipindustrie gefertigt wird, also ein kreisförmiger Wafer der Größe 2 Zoll, 3 Zoll, 4 Zoll oder 6 Zoll verstanden. Der technische Vorteil besteht hierbei in der guten Ausnutzung der kommerziell erhältlichen, standardisierten Wafergrößen. Es wird somit vorteilhafterweise genau ein Standardwafer zu genau einem MIM prozessiert (welches dann in genau einem Konzentratorsystem zum Einsatz kommen kann (vgl. nachstehend Figur 6).

Allerdings ist bei einem runden Wafer / nahezu runden MIM zu beachten, dass die einzelnen Solarzellensegmente in Richtung zum Rand hin (in Richtung R gesehen vom Zentrum Z nach außen) immer kürzer werden: Ihre Ausdehnung bzw. Länge 1 wird somit in Richtung zum Rand hin immer kleiner. Vorteilhafterweise wird nun erfindungsgemäß nicht nur die zum Rand hin abfallende Lichtintensität ausgeglichen, sondern ebenso die zum Rand hin geringer werdende Länge 1: Die Fläche der außen liegenden Solarzellensegmente 1a' wird somit so weit vergrößert, dass ein solches außen liegendes Solarzellensegment 1a' trotz verringerter Gesamtlänge 1 und trotz der zum Rand hin abfallenden Lichtintensität denselben Strom I erzeugt wie ein im Zentrum angeordnetes Solarzellensegment 1i' mit größerer Länge 1 unter der dort höheren Lichtintensitätsbestrahlung. Eine solche Ausbildung hat den Vorteil, dass auf optimale Art und Weise ein großer Teil des Wafers als aktive Zellfläche genutzt werden kann. Bevorzugt beträgt dabei die mittlere Ausdehnung mindestens eines der integrierten Solarzellensegmente senkrecht zur Reihenrichtung (also die Ausdehnung in Richtung L, siehe Figur 4) bzw. die Länge mindestens eines der integrierten Solarzellensegmente mindestens 70 %, bevorzugt mindestens 80 %, bevorzugt mindestens 90 % der mittleren Ausdehnung des Wafers senkrecht zur Reihenrichtung gesehen am Ort dieses Solarzellensegments. Besonders bevorzugt gelten diese genannten Werte nicht nur für mindestens eines der integrierten Solarzellensegmente, sondern für mehrere oder alle integrierten Solarzellensegmente. Bevorzugt beträgt hierbei die Gesamtfläche aller Solarzellensegmente mindestens 50 %, bevorzugt mindestens 60 %, bevorzugt mindestens 70 %, bevorzugt mindestens 80 %, bevorzugt mindestens 90 % der Gesamtfläche des verwendeten Wafers.

Wie Figur 4 zeigt, sind die einzelnen Solarzellensegmente senkrecht zur Reihenrichtung gesehen (also in Längsrichtung L gesehen) parallel zueinander in der Waferebene angeordnet. Die einzelnen in der Reihe angeordneten, elektrisch in Serie geschalteten Solarzellensegmente (dies gilt ebenso für die anderen Ausführungsbeispiele) der Reihenanordnung von Solarzellensegmenten sind hierbei mit ihren solarstrahlungssensitiven Flächen parallel zueinander und in einer Ebene (hier der Waferebene) angeordnet.

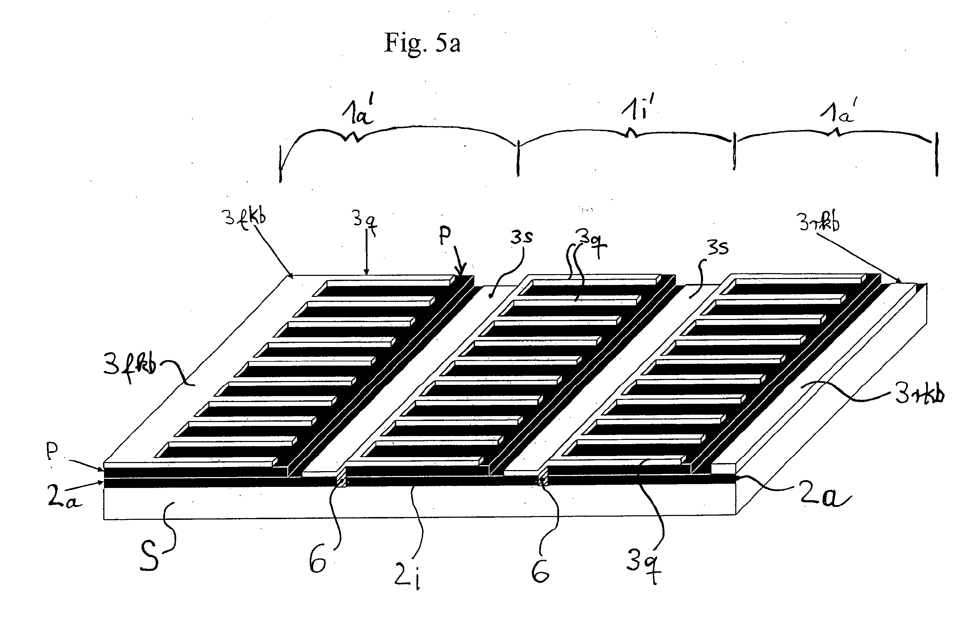

Figur 5a zeigt ein einfaches, monolithisch integriert serienverschaltetes Solarzellenmodul, MIM. Das Modul ist als aktive Halbleiterschicht P auf einem elektrisch nicht-leitfähigen Material bzw. inaktiven Substrat S (hier ebenfalls ein Halbleiter) aufgebaut. Die aktiven Schichten P sind durch eine Grabenstruktur in die einzelnen Solarzellensegmente 1a' und 1i' (hier gezeigt: zwei außenliegende Solarzellen 1a' und diese innenliegende Solarzelle 1i' mit geringerer solarstrahlungssensitiver Fläche) unterteilt, welche auf der Halbleiterseite voneinander elektrisch isoliert sind. Die in Figur 5a obenliegend gezeigte Fläche ist die Vorderseite bzw. Frontseite des Solarzellenmoduls, die untenliegende Fläche (nicht gezeigt) bzw. die untere Oberfläche des Substrats S die Rückseite (also die der Einstrahlungsseite bzw. Sonnenseite abgewandte Seite) des Solarzellenmoduls. Der Aufbau ist wie folgt: Auf dem Substrat S ist eine elektrisch hoch leitfähige Halbleiterschicht 2, die Querleitschicht 2 angeordnet. Diese Querleitschicht 2 ist durch Gräben in einzelne Segmente gemäß den einzelnen Solarzellensegmenten 1a', 1i' unterteilt. Auf diesen einzelnen Segmenten der Querleitschicht 2 (die Segmente sind für die außenliegenden Solarzellen mit 2a und für die innenliegenden Solarzellen mit 2i bezeichnet) befinden sich jeweils die photosensitiven Halbleiterschichten P der einzelnen Solarzellensegmente. Die photosensitiven Halbleiterschichten P bedecken dabei jeweils die Querleitschichten 2a, 2i nicht vollständig, so dass, wie nachfolgend noch näher beschrieben, ein Teilbereich der frontseitigen Oberfläche der Querleitschichten 2a, 2i mit einem stegförmigen Metallkontakt 3s kontaktiert ist.

Die Gräben zwischen den einzelnen Solarzellensegmenten 1a', 1i' bzw. zwischen den ihnen zugeordneten Querleitschichten 2a, 2i sind jeweils mit einem Isolator 6 aufgefüllt. Dieser Isolator ermöglicht es, dass die Querleitschicht 2a, 2i eines Solarzellensegments 1a', 1i', wie nachfolgend noch näher beschrieben, mittels des stegförmigen Metallkontakts 3s und von diesem über die Isolation 6 hinübergreifenden Querfinger 3q mit der Frontseite eines benachbarten Solarzellensegments 1a', 1i' kontaktiert ist. Die Querleitschichten 2a, 2i bilden somit jeweils den Rückseitenkontakt der einzelnen MIM-Segmente bzw. Solarzellensegmente. Die Querleitschichtelemente bzw. die Querleitschicht wird hierbei jeweils auf einem schmalen Streifen mit einem Metallkontakt 3 in Form eines metallenen Steges 3s kontaktiert. Die elektrisch leitfähige Querleitschicht 2 ist somit durch den aufgebrachten Metallkontakt 3 elektrisch kontaktiert. Der im wesentlichen rechteckförmige Oberflächenbereich, auf dem die Metallschicht 3 die Querleitschicht 2 kontaktiert, wird im folgenden auch als stegförmiger Rückkontakt 3s bezeichnet. Der Metallkontakt 3 setzt sich vom stegförmigen Rückkontakt 3s über den elektrischen Isolator 6 hinweg von dem entsprechenden Solarzellenelement bis auf die Vorderseite bzw. Frontseite des ihm unmittelbar benachbarten, nächsten Segments fort. Auf diese Weise ist die monolithische Serienverschaltung der Solarzellensegmente 1a', 1i' realisiert.

Damit auf der aktiven Solarzellensegment-Vorderseite (oben liegende Frontseite) das Sonnenlicht möglichst ungehindert passieren kann, ist die Metallschicht 3 in diesem Bereich bzw. oberhalb der aktiven Halbleiterschichtbereiche P in Form einer Vielzahl von zueinander parallel verlaufenden Frontkontaktfingern 3q strukturiert. Diese Frontkontaktfinger bzw. Querfinger 3q verlaufen senkrecht zum Steg 3s und sind mit diesem elektrisch im Bereich über dem Isolator 6 kontaktiert. Der Steg 3s und die Querfinger 3q bilden somit eine elektrisch leitfähige Kammstruktur, welche über zwei benachbarte Solarzellensegmente hinüberreicht und diese elektrisch miteinander verbindet. Den elektrischen Abschluss der gezeigten Reihenschaltung des MIM bildet auf der einen Seite (hier die linke Seite) ein stegförmiger Frontkontaktbus 3fkb, welcher die Querfinger 3q des außenliegendsten äußeren Solarzellensegments elektrisch kontaktiert bzw. mit diesen auf der Solarzellensegment-Vorderseite eine Kammstruktur ausbildet. In dem Frontkontaktbus 3fkb enden die Finger des außenliegendsten äußeren Solarzellensegments. Das auf der gegenüberliegenden Seite bzw. am anderen Ende der Reihenschaltung angeordnete, außenliegendste Solarzellensegment (hier ganz rechts gezeigtes Element 1a') weist einen Rückkontaktbus 3rkb auf, welcher analog wie die Stege 3s den der Sonnenseite zugewandten Oberflächenabschnitt der Querleitschicht 2a kontaktiert.

Wie sich dem Fachmann bereits aus dem vorangegangenen Text erschlossen hat, ist jedes der Solarzellensegmente 1a', 1i' eine einzelne Solarzelle, so dass umgekehrt unter dem Begriff der Solarzelle in der vorliegenden Erfindung entweder eine diskrete Solarzelle auf einem eigenen Chip oder ein MIM-Segment zu verstehen ist.

Typischerweise verursacht die Querleitschicht 2 (bzw. deren Segmente 2a, 2i) einen großen Teil des elektrischen Serienwiderstands. Mit steigender Segmentbreite (Ausdehnung in Reihenanordnungsrichtung) nehmen die Serienwiderstandsverluste der einzelnen Solarzellensegmente in der Querleitschicht stark zu. Grundsätzlich sollten derartige MIM-Segmente, welche auf die in der Figur 5a gezeigte Art und Weise kontaktiert sind, somit eine gewisse Breite nicht überschreiten.

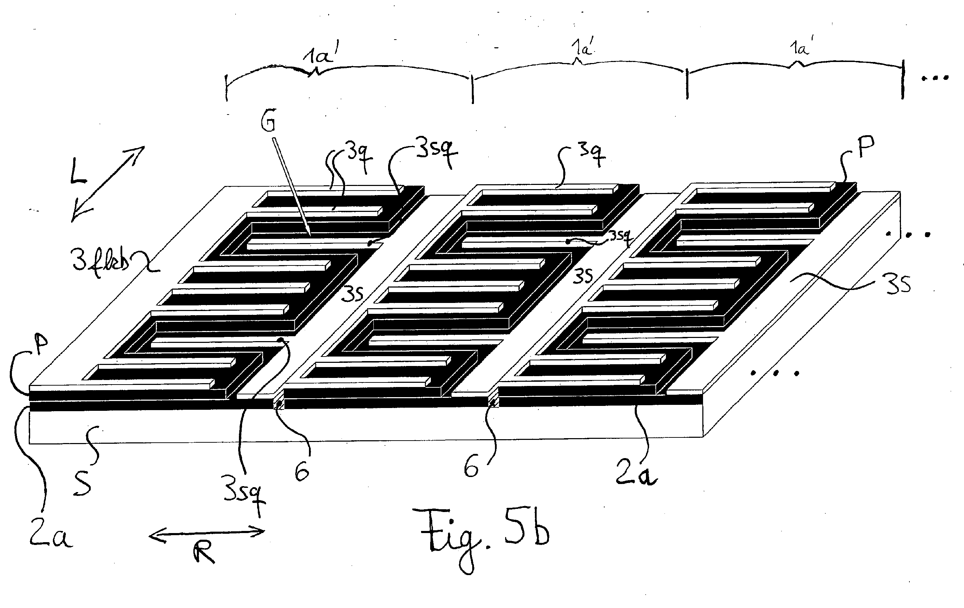

Figur 5b zeigt nun jedoch, wie erfindungsgemäß bei akzeptablen Serienwiderstandsverlusten wesentlich breitere Solarzellensegmente möglich sind:

Der in Figur 5b gezeigte Aufbau entspricht grundsätzlich demjenigen, welcher in Figur 5a gezeigt ist, so dass hier lediglich die Unterschiede beschrieben sind. Gezeigt sind hier zudem nur drei äußere Solarzellen 1a' einer Reihenanordnung, welche aus einer Vielzahl von einzelnen äußeren Solarzellensegmenten 1a' und inneren Solarzellensegmenten 1i' (nicht gezeigt) besteht.

In Längsrichtung (L-Richtung), d.h. senkrecht zur Reihenanordnungsrichtung R gesehen, sind aus den aktiven Schichten P der äußeren Solarzellenelemente 1a' beabstandet voneinander jeweils mehrere einzelne Gräben G entfernt (beispielsweise durch Ausätzung). Diese Gräben verlaufen mit ihrer Grabenlängsachse in Richtung R und sind nicht über die gesamte Breite der einzelnen Solarzellensegmente 1a' entfernt, sondern lediglich über einen Teilbereich davon, so dass die aktive Schicht P in Form eines in L-Richtung verlaufenden Balkens, von dem in L-Richtung gesehen beidseits der Gräben G jeweils Querleitschichtsegmente in R-Richtung abstehen, ausgebildet ist.

In den Gräben G ist nun die aktive Schicht P der einzelnen Solarzellensegmente vollständig entfernt, so dass die Oberfläche der darunterliegenden Querleitschicht 2a freiliegt. Entlang der Grabenlängsachse und mittig in den einzelnen Gräben G sind nun beabstandet von den stehengebliebenen Segmenten der aktiven Schicht P (und somit elektrisch isoliert davon) auf der frontseitigen Oberfläche der Querleitschicht 2a Querleitfinger 3sq ausgebildet. Diese Metallfinger 3sq sind auf der den Querfingern 3q gegenüberliegenden Seite elektrisch leitend mit der Längsbalkenstruktur 3s auf der Oberseite der aktiven Schicht P verbunden: Ausgehend von dem stegförmigen Rückseitenkontakt 3s einer Solarzelle verlaufen senkrecht zur Steglängsrichtung gesehen somit auf einer Seite des Steges 35 die ebenfalls einen Teil des Rückseitenkontakts dieser Solarzelle ausbildenden Querleitfinger 3sq, während auf der gegenüberliegenden Seite an den Metallsteg 3s dieser Solarzelle die den Frontseitenkontakt der benachbarten Solarzelle ausbildenden Querleitfinger 3q angeschlossen sind. Die einzelnen Querleitfinger 3sq des Rückseitenkontakts eines Solarzellensegments verlaufen dabei kammförmig verzahnt innerhalb der Kammstruktur der Frontseitenkontaktfinger 3q desselben Solarzellensegments (reißverschlussförmiges Ineinandergreifen des Rückseitenkontakts und des Frontseitenkontakts).

Figur 5b skizziert somit ein MIM, bei dem sich erfindungsgemäß die Metallisierungen 3 in Form von zusätzlichen Rückkontaktfingern 3sq über die Querleitschicht 2a erstrecken. Diese Rückkontaktfinger 3sq verlaufen in den Gräben G, welche in die aktiven Solarzellenschichten P geätzt wurden. Der Rückkontakt erhält dadurch ebenso wie der Vorderkontakt 3q eine Kammform. Der stegförmige Kontakt bleibt dabei erhalten.

Es ist jedoch auch alternativ denkbar, die Querleitschicht nur um die Finger 3sq freizulegen. In der Längsrichtung sind dann nur schmale, tiefe Gräben geätzt, welche die Halbleiterschicht in Segmente unterteilen. Die Finger 3sq verlaufen dann einzeln über die Isolationsschicht 6 auf die Vorderseite des nächsten Segments und sind erst dort durch einen Bus verbunden. Der Ätzprozess zum Freilegen der Querleitschicht erfordert relativ weite Toleranzen, wohingegen es einfacher ist, schmale Gräben in Längsrichtung zu ätzen. Es ist daher auch möglich, die inaktive Segmentfläche durch den Verzicht auf den stegförmigen Kontakt 3s zu verringern.

Durch die Rückkontaktfinger 3sq werden die Stromwege in der Querleitschicht 2 verkürzt. Es sind so erfindungsgemäß bei akzeptablen Serienwiderstandsverlusten deutlich breitere Segmente 1a' möglich.

Vorteilhafterweise sind hierbei, wie in Figur 5b gezeigt, erfindungsgemäß lediglich die außenliegenden, eine höhere Segmentbreite aufweisenden Solarzellensegmente 1a' mit diesen zusätzlichen Rückseitenkontaktfingern 3sq rückseitig kontaktiert, wohingegen die inneren, eine geringere Segmentbreite aufweisenden Solarzellensegmente 1i' (hier nicht gezeigt) lediglich wie in Figur 5a gezeigt, den stegförmigen Rückseitenkontakt 3s aufweisen. Dies hat den Vorteil, dass bei den inneren Solarzellensegmenten der Anteil an photovoltaisch nicht aktiver Fläche nicht unnötigerweise erhöht wird (was den Wirkungsgrad verringert), sondern lediglich bei den außenliegenden Solarzellensegmenten 1a'.

Erfindungsgemäß können somit Solarzellenelemente mit lediglich stegförmigen Kontakten auf der Querleitschicht gemeinsam mit Segmenten mit kammförmigen Kontakten auf der Querleitschicht in einem Solarzellenmodul oder sogar auf einem MIM-Chip verwendet werden: Es ist dann der Rückseitenkontakt von mindestens einem Segment (äußeres Segment) als kammförmiger Kontakt ausgebildet und der Rückseitenkontakt bei mindestens einem weiteren Segment (inneres Segment) als einfacher stegförmiger Kontakt. Durch diese Kombination beider Segmentvarianten ist eine weite Variation der Segmentbreiten (wie sie erfindungsgemäß vorteilhaft ist) auf effiziente Art und Weise möglich: Ansonsten hätten sehr breite Segmente einen zu hohen Serienwiderstand oder sehr schmale Segmente wären derart schmal, dass die Serienverschaltung zu einer unverhältnismäßig hohen inaktiven Fläche führen würde.

Erfindungsgemäß kann somit ein MIM ausgebildet werden, bei dem die außen liegenden breiten Solarzellensegmente 1a' mit Rückseitenfingern 3sq versehen sind und bei dem die schmalen, dem Zentrum zugewandten Segmente 1i' ohne solche Rückseitenfinger 3sq kontaktiert werden. Im Fall der innen liegenden Segmente 1i' wird somit die Querleitschicht 2 lediglich durch einen schmalen Streifen elektrisch kontaktiert. Die zusätzlichen Metallfinger 3sq der außen liegenden Segmente 1a' können so ausgebildet werden, dass die Metallfinger in geätzten Gräben verlaufen. Vorteilhafterweise können diese Metallfinger wie in Fig. 5b gezeigt mit den Metallfingern des Frontseitenkontakts des entsprechenden Solarzellensegments ineinander greifen (sogenannte interdigitated fingers).

Fig. 6 skizziert die wesentlichen Elemente eines erfindungsgemäßen Konzentratorsystems für Solarstrahlung: Dies sind ein hier aus drei einzelnen Reihen von Solarzellen bestehendes, erfindungsgemäßes Solarzellenmodul 1 sowie eine Fokussieroptik 4. Die Solarstrahlung wird mithilfe der Fokussieroptik 4 (beispielsweise Fresnellinsensystem oder Hohlspiegel) auf das Solarzellenmodul 1 (welches hier aus den drei einzelnen Reihen 1-1 bis 1-3 besteht, welche jeweils einzelne innere und äußere Solarzellen 1i und 1a wie vorbeschrieben aufweisen) fokussiert. Hierbei kann die Fokussieroptik zur Nachführungskorrektur eine elektrisch angetriebene, mechanische Sonnennachführung ("Tracker") aufweisen.

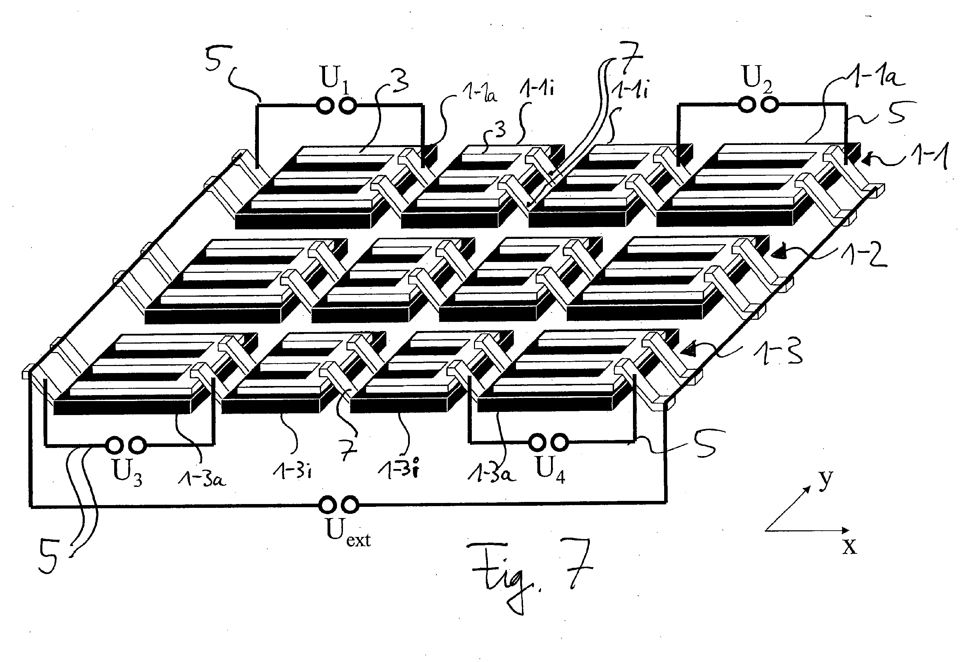

Fig. 7 skizziert nun, wie mit einer erfindungsgemäßen Konzentratorsystemanordnung, wie sie in Fig. 6 skizziert ist, die Sonnennachführung korrigiert werden kann. Das Solarzellenmodul 1 des Konzentratorsystems besteht hier aus drei einzelnen Reihen von jeweils vier einzelnen Solarzellen. Die einzelnen Reihenanordnungen von Solarzellen 1-1, 1-2 und 1-3 sind hierbei senkrecht zur Reihenrichtung R gesehen beabstandet voneinander und parallel zueinander angeordnet (Reihenrichtung hier die x-Richtung). Jede einzelne Reihenanordnung besteht aus vier einzelnen Solarzellen, zwei äußeren Solarzellen 1a und zwei inneren Solarzellen 1i, welche jeweils in Reihenrichtung beabstandet voneinander angeordnet und miteinander in Serie verschaltet sind. Die drei Reihenanordnungen 1-1, 1-2 und 1-3 sind untereinander elektrisch parallel verschaltet (siehe die außenliegenden Leitungen zum Anlegen der Spannung Uₑₓₜ). Gezeigt ist ein Solarzellenmodul mit herkömmlicher Verschaltung. Die Verschaltung erfolgt durch metallische Zellverbinder 7, welche die Rückseite einer Solarzelle einer Reihe mit der Vorderseite der jeweils nächsten Solarzelle dieser Reihe verbinden. Ebenso kann jedoch an dieser Stelle auch eine entsprechende Verschaltung aus MIMs (siehe vorhergehende Beispiele) eingesetzt werden. Die in Figur 7 gezeigte Anordnung weist nun eine Nachführungskorrektureinheit 5 auf, deren wesentliche Elemente hier skizziert sind. Eine äußere Spannung Uₑₓₜ wird an alle serienverschalteten Reihen, also an jede der drei gezeigten Reihenanordnungen von Solarzellen angelegt, wobei die Spannung für alle serienverschalteten Reihen von Solarzellen identisch ist. Die Spannung Uₑₓₜ kann hierbei von einer Wechselrichtereinheit vorgegeben werden (die Spannung wird z.B. außenseitig der beiden außen liegenden Solarzellen 1-1a angelegt, fällt also über alle vier Solarzellen einer jeden Reihe ab). Zudem weist die Nachführungskorrektureinheit 5 vier Spannungsabgriffe auf, mit denen jeweils die Spannungen an den außen liegenden Solarzellen 1a der beiden außen liegenden Reihenanordnungen 1-1 und 1-3, welche beim Betrieb bzw. beim Einstrahlen von Solarstrahlung unter Anlegen der externen Spannung Uₑₓₜ abfallen, abgegriffen werden (es werden somit die an den Solarzellen 1-1a und 1-3a abfallenden Spannungen U₁, U₂, U₃ und U₄ abgegriffen, wobei die Spannungen U₁ und U₂ an den äußeren Solarzellen 1-1a der ersten Reihenanordnung 1-1 abfallen und die Spannungen U₃ und U₄ an den beiden außen liegenden Solarzellen 1-3a der dritten Reihenanordnung 1-3). Durch Vergleich einzelner Spannungswerte, welche aus den Spannungen U₁ bis U₄ gewonnen werden, ist es nun wie nachfolgend beschrieben möglich, die Position der Lichteinstrahlung bzw. des Lichtflecks auf dem gezeigten Solarzellenmodul 1-1 bis 1-3 zu überprüfen und ggf. zu korrigieren.

Die einzelnen Solarzellensegmente 1-1a bis 1-3a mit höherer Breite b haben einen höheren Serienwiderstand als die innen angeordneten Solarzellen. Dies ist zwar im Allgemeinen von Nachteil, da der Serienwiderstand die Leistung der Solarzellen schmälert, allerdings lässt sich dieser unterschiedliche Serienwiderstand (im Vergleich zu den Serienwiderständen der inneren Solarzellen 1-1i bis 1-3i), welcher durch die unterschiedliche Segment- oder Solarzellenbreite verursacht wird, auf geschickte Weise ausnutzen, um die Position des Lichtflecks auf dem Solarmodul 1 zu überprüfen und ggf. zu korrigieren.

Die Fig. 7 zeigt hierzu ein Solarmodul mit drei parallel verschalteten Strängen (Reihenanordnungen) mit je vier serienverschalteten Solarzellen oder Segmenten 1a, 1i. Beim Betrieb des Moduls 1 zur Erzeugung elektrischer Leistung wird nun wie beschrieben von außen die externe Spannung Uₑₓₜ vorgegeben bzw. angelegt, die vorteilhafterweise so gewählt wird, dass die elektrische Ausgangsleistung des Solarzellenmoduls maximal wird. Die äußeren, breiteren Solarzellen 1a liefern bei Anlegen dieser Spannung aufgrund ihres höheren Serienwiderstandes eine niedrigere Spannung (Spannungswerte U₁ bis U₄) als die inneren Solarzellen 1i. Der Unterschied in den gelieferten Spannungen zwischen den äußeren und inneren Solarzellen wird umso größer, je höher der Strom durch den Solarzellenstrang ist, je größer also die auf den Solarzellenstrang bzw. die Solarzellen auftreffende Lichtintensität ist. Verschiebt sich also der Lichtfleck in Richtung des unteren Stranges 1-3 (also in -y-Richtung), so steigt der Strom im Strang. Es reduzieren sich somit in diesem Strang 1-3 die Spannungen U₃ und U₄ an den äußeren Solarzellen 1-3a wegen des höheren Serienwiderstandes dieser Solarzellen, die Spannung der inneren Solarzellen 1-3i steigt, und die externe Spannung Uₑₓₜ ist für alle einzelnen Stränge 1-1 bis 1-3 konstant und gleich gewählt. Umgekehrt ergibt sich, dass die Spannungen U₁ und U₂ bei einer Verschiebung des Lichtflecks nach unten steigen. Der Abgriff der Spannungen U₁ bis U₄ kann auch jeweils über mehrere äußere Solarzellen einer Reihenanordnung erfolgen. Zudem ist es ebenso möglich, die Spannungen über äußere und innere Solarzellen oder auch nur über innere Solarzellen einer Reihenanordnung abzugreifen, sofern nur gewährleistet ist, dass die mittlere solarstrahlungssensitive Fläche der spannungsabgegriffenen Solarzellen einer Reihe eine andere ist, als die mittlere solarstrahlungssensitive Fläche aller Solarzellen derselben Reihe.

Ist somit der Fall U₁ + U₂ > U₃ + U₄ gegeben, so bedeutet dies demnach eine Verschiebung des Lichtflecks nach unten, also in -y-Richtung. Umgekehrt bedeutet U₁ + U₂ < U₃ + U₄ eine Verschiebung des Lichtflecks nach oben, also in +y-Richtung. Dieser Zusammenhang lässt sich nach entsprechender Eichung zur Bestimmung der Verschiebung des Lichtflecks in y-Richtung nutzen. Damit kann die Sonnennachführung bzw. die Sonnenlichteinfallposition auf dem Solarzellenmodul des Konzentratorsystems in y-Richtung mit dieser Information korrigiert werden. Dies hat den Vorteil, dass ein separater Sensor entfällt.

Die beschriebene Methode der Korrektur basiert auf den unterschiedlichen Segmentbreiten b und den damit verbundenen unterschiedlichen Serienwiderständen: Für eine Reihenschaltung von Solarzellen mit identischer Breite und identischem Serienwiderstand ist hingegen der Spannungsverlust im Serienwiderstand für jede Zelle nahezu gleich, so dass im Falle des in Fig. 2 gezeigten Standes der Technik die vorbeschriebene erfindungsgemäße Methode nicht angewendet werden kann.

Ebenso ist eine Korrektur der Lichteinfallposition in Reihenrichtung bzw. x-Richtung möglich: Wandert der Lichtfleck in +x-Richtung über das Modul, so sinkt der Strom und damit auch die Spannung in den links gezeigten Solarzellen ab, bis sie schließlich strombegrenzend werden oder der zusätzliche Strom über eine ggf. parallel geschaltete Bypassdiode abfließt. Umgekehrt führt die Anhebung der Stromgeneration in den rechten Solarzellen auch zu einer höheren Spannung. Liegt somit der Fall U₁ + U₃ < U₂ + U₄ vor, so zeigt dies demnach eine Verschiebung der Lichtposition nach rechts in +x-Richtung an. Umgekehrt bedeutet der Fall U₁ + U₃ > U₂ + U₄ eine Verschiebung des Lichtflecks nach links in die -x-Richtung. Diese x-Auswertung bzw. x-Korrektur der Nachführung der Einstrahlungsposition funktioniert auch bei Solarzellenmodulen mit konstanten Segmenten, vorausgesetzt, dass sich diese nicht hinter einer homogenisierenden Optik befinden.

Die im Zusammenhang mit dem in Figur 7 gezeigten Beispiel geschilderte Realisierung eines Korrekturverfahrens zur Korrektur der Sonnennachführung kann erfindungsgemäß im allgemeinen wie nachfolgend beschrieben realisiert werden.

Es wird ein Solarzellenmodul ausgebildet, welches mehrere serienverschaltete Einzelstränge bzw. -reihen von Solarzellen aufweist, wobei die einzelnen serienverschalteten Stränge untereinander im Solarzellenmodul parallel verschaltet sind (vgl. auch die in Figur 7 gezeigte Verschaltung). In der Nachführeinheit wird dann eine Nachführungskorrektureinheit 5 so vorgesehen, dass in einem ersten serienverschalteten Strang des Solarzellenmoduls eine erste Spannung an mindestens einer Solarzelle dieses Strangs abgegriffen wird. Ebenso wird an einem zweiten Strang, welcher nicht mit dem ersten Strang identisch ist, an mindestens einer Solarzelle dieses Strangs eine zweite Spannung abgegriffen. Die beiden Spannungsabgriffe können hierbei also jeweils über eine oder über mehrere in Reihe geschaltete einzelne Solarzellen des jeweiligen Strangs erfolgen. Wesentlich ist nun, dass bauartbedingt jeweils mindestens eine Solarzelle in jedem Strang einen anderen Serienwiderstand aufweist als mindestens eine andere der Solarzellen desselben Strangs. Es kann sich hierbei um eine Solarzelle handeln, welche einen größeren Serienwiderstand aufweist, oder um eine Solarzelle, welche einen kleineren Serienwiderstand aufweist. Unterschiedliche Serienwiderstände lassen sich beispielsweise durch unterschiedliche solarstrahlensensitive Flächen der Solarzellen realisieren; insbesondere ist eine Realisierung durch eine unterschiedliche Solarzellenbreite möglich (siehe vorangehende Beschreibung).

Neben der Segmentbreite können auch andere Solarzellenparameter wie der Kontaktfingerabstand oder die Kontaktfingerbreite variiert werden, um unterschiedliche Serienwiderstände der Solarzellen zu erreichen.

Analog zu der für Figur 7 beschriebenen Vorgehensweise ist es dann möglich, die beiden beschriebenen Spannungen zu vergleichen und aus dem Vergleichsergebnis durch Auswertung zu bestimmen, in welcher der beiden Richtungen senkrecht zur Reihenanordnung der einzelnen Stränge die Nachführung durch die Nachführungskorrektureinheit korrigiert werden muss. Es wird somit eine Variation der Serienwiderstände in den einzelnen Solarzellen eines serienverschalteten Strangs von Solarzellen und die damit verbundene Spannungsänderung zur Korrektur der Sonnennachführung senkrecht zur Reihenanordnungsrichtung benutzt. Dabei kann der Serienwiderstand in den vermessenen Solarzellen überdurchschnittlich, aber auch unterdurchschnittlich sein. Unter einem bauartbedingt anderen Serienwiderstand wird hierbei ein Widerstandsunterschied verstanden, welcher mindestens so groß ausgebildet ist, dass er sich von herstellungsbedingt zufälligen Fluktuationen (beispielsweise der Segmentbreiten) ausreichend und messbar unterscheidet.

Alternativ oder kumulativ zu einem solchen Aufbau kann auch eine Korrektur der Nachführung in einer Richtung parallel zur Reihenanordnungsrichtung bzw. Richtung der Serienverschaltung der einzelnen Stränge erfolgen, indem eine dritte Spannung über mindestens eine Solarzelle einer Reihenanordnung und eine vierte Spannung über mindestens eine weitere Solarzelle dieser Reihenanordnung (wobei sich mindestens eine der Solarzellen, über die die dritte Spannung abgegriffen wird, von mindestens einer der Solarzellen, über die die vierte Spannung abgegriffen wird, unterscheidet, d.h. es existiert mindestens eine Solarzelle, über die entweder nur die dritte Spannung oder nur die vierte Spannung abgegriffen wird) abgegriffen wird. Diejenige Anzahl von Solarzellen einer einzelnen Reihe, über die jeweils eine solche Spannung abgegriffen wird, wird nachfolgend auch alternativ als Abgriffsteilreihe bezeichnet. Der Abgriff über eine solche Abgriffsteilreihe erfolgt hierbei jeweils über mindestens eine einzelne Solarzelle, kann jedoch auch über mehrere Solarzellen erfolgen. Analog der vorstehend geschilderten Vorgehensweise bei der ersten und der zweiten Spannung, dann somit diejenige der beiden Richtungen parallel zur Reihenanordnungsrichtung bestimmt werden, in der die Nachführung korrigiert werden muss. Durch geeignete Vergleichskombinationen der ersten, zweiten, dritten und vierten Spannung kann somit eine Korrektur der Nachführung in beliebiger Richtung senkrecht zur Sonneneinstrahlungsrichtung realisiert werden.

Für die Korrektur mit Spannungsabgriff in verschiedenen Reihen ist es wichtig, dass der gemittelte Solarzellen-Serienwiderstand in einer Abgriffs-Teilreihe vom gemittelten Solarzellen-Serienwiderstand jener Reihe abweicht, in der sich die Abgriffs-Teilreihe befindet. Eine einzelne Solarzelle mit erhöhtem Serienwiderstand in der Abgriffs-Teilreihe bei ansonsten konstantem Serienwiderstand ist ausreichend. Allerdings ist eine Korrektur dann nicht möglich, wenn die Abgriffs-Teilreihe Solarzellen enthält welche zwar verschiedene Serienwiderstände haben, jedoch Abgriffs-Teilreihe und Reihe jeweils im Mittel den gleichen Solarzellenwiderstand haben.

## Patentansprüche

1. Solarzellenmodul (1) umfassend mindestens drei im wesentlichen in einer Reihe angeordnete, elektrisch in Serie geschaltete Solarzellen (Reihenanordnung von Solarzellen 1a, 1i)
***dadurch gekennzeichnet, dass*** mindestens eine Solarzelle (innenliegende Solarzelle 1i) der Reihenanordnung von Solarzellen eine geringere solarstrahlungssensitive Fläche aufweist als zwei in Reihenrichtung (R) gesehen beidseits dieser innenliegenden Solarzelle angeordnete Solarzellen (außenliegende Solarzellen 1a) der Reihenanordnung von Solarzellen.

2. Solarzellenmodul nach dem vorhergehenden Anspruch
***dadurch gekennzeichnet, dass*** die solarstrahlungssensitive Fläche der Solarzellen der Reihenanordnung von Solarzellen vom Zentrum der Reihenanordnung nach außen hin zu den Rändern der Reihenanordnung zunimmt.

3. Solarzellenmodul nach einem der vorhergehenden Ansprüche
***dadurch gekennzeichnet, dass*** das Verhältnis der solarstrahlungssensitiven Flächen mindestens zweier Solarzellen der Reihenanordnung von Solarzellen durch Variation der Ausdehnung (Breite b) der Solarzellen in Reihenrichtung (R) eingestellt ist, insbesondere ausschließlich durch Variation der Breite b der Solarzellen in Reihenrichtung eingestellt ist.

4. Solarzellenmodul nach einem der vorhergehenden Ansprüche
***dadurch gekennzeichnet, dass*** das Solarzellenmodul (1) als monolithisch auf einem Wafer integriertes, serienverschaltetes Modul (monolithic interconnected module 1', MIM) ausgebildet ist, wobei die Solarzellen (1a, 1i) der Reihenanordnung von Solarzellen als in Reihenrichtung aufeinander folgend auf dem Wafer integrierte Solarzellensegmente (1a', 1i') ausgebildet sind, oder dass das Solarzellenmodul (1) eine Verschaltung mehrerer derartiger MIMs aufweist.

5. Solarzellenmodul nach dem vorhergehenden Anspruch
***gekennzeichnet durch*** einen im Wesentlichen kreisförmigen Wafer, insbesondere einen 2''-, 3''-, 4''- oder 6''-Standardwafer, und/oder
**dadurch**, dass das Solarzellenmodul als ein einziges, auf einem einzigen Wafer integriertes MIM ausgebildet ist.

6. Solarzellenmodul nach einem der beiden vorhergehenden Ansprüche
***dadurch gekennzeichnet, dass*** die einzelnen Solarzellensegmente in Reihenrichtung und von Innen, also von dem mindestens einen innenliegenden Solarzellensegment, nach Außen, also jeweils hin zu den beiden außenliegenden Solarzellensegmenten, gesehen eine Breitenzunahme aufweisen, welche eine oder die Längenabnahme der Solarzellensegmente senkrecht zur Reihenrichtung gesehen jeweils mindestens ausgleicht, also so ausgebildet ist, dass die solarstrahlungssensitive Fläche der Solarzellenelemente in Richtung nach Außen hin gesehen mindestens gleich bleibt.

7. Solarzellenmodul nach einem der vorhergehenden Ansprüche
***dadurch gekennzeichnet, dass*** mindestens eine der innenliegenden Solarzellen (1i) eine diese Solarzelle auf ihrer der solaren Einstrahlungsseite abgewandten Rückseite elektrisch kontaktierende, elektrisch leitfähige, bevorzugt halbleitfähige Querleitschicht (2i) und einen im wesentlichen stegförmig ausgebildeten elektrischen Rückseiten-Metallkontakt (3s), welcher diese elektrisch leitfähige Querleitschicht (2i) elektrisch kontaktiert, aufweist und
dass mindestens eine der außenliegenden Solarzellen (1a) eine diese Solarzelle auf ihrer der solaren Einstrahlungsseite abgewandten Rückseite elektrisch kontaktierende, elektrisch leitfähige, bevorzugt halbleitfähige Querleitschicht (2a) und einen im wesentlichen kammförmig, insbesondere mit einem Steg (3s) und mit mehreren von diesem Steg im wesentlichen senkrecht abgehenden Querfingern (3sq), ausgebildeten elektrischen Rückseiten-Metallkontakt (3s, 3sq), welcher diese elektrisch leitfähige, bevorzugt halbleitfähige Querleitschicht (2a) elektrisch kontaktiert, aufweist.

8. Solarzellenmodul nach einem der vorhergehenden Ansprüche
***gekennzeichnet durch*** mehrere senkrecht zu ihrer seriellen Schaltrichtung gesehen im Wesentlichen parallel zueinander und beabstandet voneinander angeordnete Reihenanordnungen von Solarzellen (1-1, 1-2, ..., 1-n mit n ∈ N), wobei jede dieser Reihenanordnungen wie im kennzeichnenden Teil von Anspruch 1 oder in einem von diesem abhängigen Anspruch beschrieben ausgebildet ist.

9. Konzentratorsystem für Solarstrahlung umfassend eine Fokussieroptik (4) zur Konzentration von Sonnenlicht in einem Fokus der Fokussieroptik, ein im Wesentlichen im Fokus der Fokussieroptik (4) angeordnetes Solarzellenmodul (1) und eine Nachführeinheit, mit welchem die Fokussieroptik (4) und das Solarzellenmodul (1) aktiv dem Sonnenstand nachführbar sind.

10. Konzentratorsystem nach dem vorhergehenden Konzentratorsystem-Anspruch
***dadurch gekennzeichnet, dass*** das Solarzellenmodul (1) nach einem der vorhergehenden Solarzellenmodul-Ansprüche ausgebildet ist.

11. Konzentratorsystem nach dem vorhergehenden Konzentratorsystem-Anspruch
***dadurch gekennzeichnet, dass*** die Solarzellen (1a, 1i) mindestens einer der Reihenanordnungen von Solarzellen des Solarzellenmoduls (1) in Reihenrichtung gesehen mit ihrer jeweiligen solarstrahlungssensitiven Fläche, bevorzugt durch Variation ihrer Breite in Reihenrichtung, an die bei Sonneneinstrahlung insbesondere aufgrund der Eigenschaften der Fokussieroptik (4) am Ort der jeweiligen Solarzelle zu erwartende eingestrahlte Strahlungsmenge je Zeiteinheit angepasst sind.

12. Konzentratorsystem nach einem der beiden vorhergehenden Konzentratorsystem-Ansprüche
***dadurch gekennzeichnet, dass*** die Flächen der Solarzellen mindestens einer der Reihenanordnungen von Solarzellen von Innen, also von der mindestens einen innenliegenden Solarzelle (1i), nach Außen, also jeweils hin zu den beiden außenliegenden Solarzellen (1a) gesehen, so zunehmen, dass die bei Sonneneinstrahlung je Solarzelle einfallende, insbesondere aufgrund der Eigenschaften der Fokussieroptik (4) nach Außen hin abnehmende Strahlungsmenge je Zeiteinheit im Wesentlichen konstant ist.

13. Konzentratorsystem nach einem der vorhergehenden Konzentratorsystem-Ansprüche
***dadurch gekennzeichnet, dass***
das Solarzellenmodul (1) mehrere Reihen von mehreren elektrisch in Serie geschalteten Solarzellen aufweist, wobei mindestens zwei dieser Reihen miteinander elektrisch parallel verschaltet sind, und
dass die Nachführeinheit eine Nachführungskorrektureinheit (5) aufweist, welche ausgebildet ist zum Abgriff einer ersten elektrischen Spannung über eine oder mehrere, jedoch nicht alle Solarzellen (erste Abgriffsteilreihe) in einer ersten dieser Reihen und zum Abgriff einer zweiten elektrischen Spannung über eine oder mehrere, jedoch nicht alle Solarzellen (zweite Abgriffsteilreihe) in einer zweiten, von der ersten Reihe verschiedenen Reihe dieser Reihen, wobei mindestens eine Solarzelle der ersten Reihe bauartbedingt einen anderen Serienwiderstand aufweist als mindestens eine andere der Solarzellen der ersten Reihe und wobei bevorzugt auch mindestens eine Solarzelle der zweiten Reihe bauartbedingt einen anderen Serienwiderstand aufweist als mindestens eine andere der Solarzellen der zweiten Reihe, und zum Vergleich dieser abgegriffenen Spannungen und zum Verschieben der Sonnenlichteinfallposition auf dem Solarzellenmodul mittels der Fokussieroptik (4) gemäß des Vergleichsergebnisses bei Abweichung dieser Sonnenlichteinfallposition von ihrer Sollposition.

14. Konzentratorsystem nach dem vorhergehenden Anspruch,
***dadurch gekennzeichnet, dass*** die Nachführungskorrektureinheit zusätzlich ausgebildet ist zum Abgriff einer dritten elektrischen Spannung über eine oder mehrere, jedoch nicht alle Solarzellen (dritte Abgriffsteilreihe) in einer dritten dieser Reihen, wobei die dritte Reihe auch identisch mit der ersten oder der zweiten Reihe sein kann, und zum Abgriff einer vierten elektrischen Spannung über eine oder mehrere Solarzellen (vierte Abgriffsteilreihe) in dieser dritten Reihe, wobei mindestens eine Solarzelle der dritten Abgriffsteilreihe nicht der vierten Abgriffsteilreihe angehört, wobei die dritte oder die vierte Spannung auch die erste oder die zweite Spannung sein kann, und dass die Nachführungskorrektureinheit ausgebildet ist zum Vergleich mindestens zweier der abgegriffenen ersten, zweiten, dritten oder vierten Spannungen und zum Verschieben der Sonnenlichteinfallposition gemäß des Vergleichsergebnisses.

15. Konzentratorsystem nach einem der vorhergehenden Konzentratorsystem-Ansprüche ***dadurch gekennzeichnet, dass*** das Solarzellenmodul (1) mehrere im Wesentlichen senkrecht zu ihrer seriellen Schaltrichtung gesehen im Wesentlichen parallel zueinander und beabstandet voneinander angeordnete Reihenanordnungen von Solarzellen (1-1, 1-2, ..., 1-n mit n ∈ N) aufweist, wobei jede dieser Reihenanordnungen wie im kennzeichnenden Teil von Anspruch 1 oder in einem von diesem abhängigen Anspruch beschrieben ausgebildet ist, und dass die Nachführeinheit eine Nachführungskorrektureinheit (5) aufweist, welche ausgebildet ist zum Anlegen einer äußeren Spannung Uₑₓₜ an mehrere der Reihenanordnungen, zum Abgriff der beim Betrieb des Konzentratorsystems unter Sonnenlichteinfall und unter Anlegen der äußeren Spannung Uₑₓₜ über jeweils mindestens eine Solarzelle (1a) in mindestens zwei verschiedenen Reihenanordnungen und/oder über jeweils mindestens eine Solarzelle (1a) an mindestens zwei unterschiedlichen Solarzellenpositionen in ein und derselben Reihenanordnung abfallenden elektrischen Spannungen, zum Vergleich mindestens zweier dieser Spannungen und zum Verschieben der Sonnenlichteinfallposition auf dem Solarzellenmodul mittels der Fokussieroptik (4) gemäß des Vergleichsergebnisses bei Abweichung dieser Sonnenlichteinfallposition von ihrer Sollposition.

16. Konzentratorsystem nach dem vorhergehenden Konzentratorsystem-Anspruch
***dadurch gekennzeichnet, dass*** die Nachführungskorrektureinheit (5) ausgebildet ist zum Abgreifen aller Spannungen ausschließlich über außenliegende Solarzellen (1a) oder dass die Nachführungskorrektureinheit (5) ausgebildet ist zum Abgreifen aller Spannungen ausschließlich über innenliegende Solarzellen (1i).

17. Verfahren zur Energieerzeugung aus Solarstrahlung wobei ein Solarzellenmodul (1) umfassend mindestens drei im wesentlichen in einer Reihe angeordnete, elektrisch in Serie geschaltete Solarzellen (Reihenanordnung von Solarzellen 1a, 1i) mittels Solarstrahlung bestrahlt wird, ***dadurch gekennzeichnet, dass*** mindestens eine Solarzelle (innenliegende Solarzelle 1i) der Reihenanordnung von Solarzellen eine geringere solarstrahlungssensitive Fläche aufweist als zwei in Reihenrichtung gesehen beidseits dieser innenliegenden Solarzelle angeordnete Solarzellen (außenliegende Solarzellen 1a) der Reihenanordnung von Solarzellen.

18. Verfahren nach dem vorhergehenden Anspruch ***dadurch gekennzeichnet, dass*** ein Solarzellenmodul und/oder ein Konzentratorsystem nach einem der vorhergehenden Vorrichtungsansprüche mit Solarstrahlung bestrahlt wird.

19. Verfahren zur Korrektur der Sonnenlichteinfallposition auf einem Solarzellenmodul eines Konzentratorsystems für Solarstrahlung ***dadurch gekennzeichnet, dass*** ein Konzentratorsystem gemäß einem der Ansprüche 13 bis 16 zur Durchführung des Verfahrens eingesetzt wird.

20. Verwendung eines Solarzellenmoduls, eines Konzentratorsystems und/oder eines Verfahrens nach einem der vorhergehenden Ansprüche zur Energieerzeugung aus Solarstrahlung und/oder eines Konzentratorsystems nach einem der Ansprüche 13 bis 15 zur Korrektur der Sonnenlichteinfallposition auf dem Solarzellenmodul des Konzentratorsystems.
